# EUROPEAN PATENT APPLICATION

(11) **EP 3 681 256 A1**
(43) Date of publication of application: **15.07.2020**
(21) Application number: 19150925.6
(22) Date of filing: 09.01.2019
(51) Int. Cl.: H05K 3/18, H05K 3/38, C23C 18/40, H05K 1/03

(54) **A METHOD FOR FORMING TRACE OF CIRCUIT BOARD**

(71) Applicant: BGT Materials Limited, Manchester M13 9PL (GB)
(72) Inventor: KU, Kuanlin, 324 Taoyuan City (TW); CHEN, SHIANG-YU, Huainan City, Anzhen Province (CN); CHANG, KUO-HSIN, 622 CHIAYI COUNTY (TW); LAI, CHUNG- PING, 302 ZHUBEI CITY (TW)
(74) Representative: Cabinet Chaillot

(57) **Abstract**

The present invention provides a method for forming trace of circuit board, applicable to enhance the yield rate of circuit board and including the following steps: (a) providing a plastic substrate; (b) forming an ink layer on a surface of the plastic substrate, the ink layer comprises at least one hollow pattern; (c) forming a copper plating layer in the at least one hollow pattern; and (d) removing the ink layer.

## Description

### FIELD OF THE INVENTION

The present invention relates to the application field of circuit board manufacture, and more particularly aim to a trace forming method of circuit board.

### BACKGROUND OF THE INVENTION

Flexible Printed Circuit (FPCs) is a highly-growth technology in the area of electrical interconnectivity. It always applied to automobiles, VCR'S, camcorders, portable devices or SLR cameras, and also applied to sophisticated military and avionics systems.

The increasingly innovative applications of FPCs technology are extending significantly because it will provide tremendous design freedoms for electronic engineers and product designers. The critical components of FPCs are the flexible films and the thin layers of conductive circuit traces.

In the known technology, there are four conventional procedures to combine the thin layers of conductive circuit traces on the flexible films, including sputtering, casting on copper, lamination and electroless plating. Sputtering and electroplating are the methods that depositing copper on the thin film directly. Casting on copper is the most common procedure in this industry. In the casting procedure, the polyimide varnish is coated on thin copper foil, then heated in temperature over 300°C for polyimide condensation. In lamination procedure, the polyimide film is adhered on copper foil.

In order to fabricate composite layers of flexible film with conductive foils, the adhesion property and flexibility are crucial issues for these technologies. However, in the current arts, which still suffer plenty of disadvantages.

As known method, sputtering and electroless plating procedures incorporate nickel as catalyst for copper deposition. Deposited copper lost adhesion property on thin film without nickel pretreatment. On further etching process, the nickel layer between the thin film and deposited copper is difficult to be etched by traditional etching chemicals coming with heavy metal, strong acids and strong oxidants. Furthermore, those etching chemicals are difficult to handle and hazardous to environment. It is essential to reduce the usage of those hazardous chemicals and to neutralize the reduction product. In addition, the pretreatment solution of this known procedure is highly corrosive and required large amount of water to completely remove it from non-metallic material surface of the thin film. Thus, the conventional procedure of surface pretreatment before plating is complicated and time consuming.

In view of this, how to provide a trace forming method to reduce usage amount of the traditional etching chemicals and enhance the yield rate of the FPCs is a technical topic to be resolved in the present invention.

### SUMMARY OF THE INVENTION

A main objective of the present invention is to enhance the yield rate of the FPCs and reduce usage amount of the traditional etching chemicals.

To achieve the above objective, the present invention provides a method for forming trace of circuit board, comprising the following steps:
(a) providing a plastic substrate;
(b) forming an ink layer on a surface of the plastic substrate, the ink layer comprises at least one hollow pattern;
(c) forming a copper plating layer in the at least one hollow pattern; and
(d) removing the ink layer.

In the above preferable implementation, in step (a), the material of the plastic substrate is polyimide and polyester.

In the above preferable implementation, in the step(a), the plastic substrate is flexible or rigid film.

In the above preferable implementation, in step (b), the material of the ink layer is a water washable mask ink.

In the above preferable implementation, the water washable mask ink comprises dispersants, solvents, binders and thickeners.

In the above preferable implementation, the water washable mask ink further comprises fillers.

In the above preferable implementation, the total weight of water washable mask ink as a basis, the concentration of the fillers is about 0.01 wt% to 30 wt%.

In the above preferable implementation, the fillers include ceramic materials, carbon materials, polymer-based fillers or glass fibers.

In the above preferable implementation, the binder contains polymers or resins with functional groups such as ester and amide bond.

In the above preferable implementation, the total weight of water washable mask ink as a basis, the concentration of the binder is about 5 wt% to 50 wt%.

In the above preferable implementation, in step (b), using screen printing to print the water washable mask ink on the plastic substrate and drying the water washable mask ink in temperature of 30 °C to 200 °C for 5 mins to 30 mins.

In the above preferable implementation, in step (c), soaking the plastic substrate with the ink layer in a alkali solution in temperature of 20 °C to 60 °C for 1 mins to 20 mins so as to modify the surface of the plastic substrate which is exposed in the at least one hollow pattern.

In the above preferable implementation, the alkali solution is 0.1 M to 10 M of sodium hydroxide solution, 0.1 M to 10 M of potassium hydroxide or 0.1 M to 10 M of mixture of sodium hydroxide and potassium hydroxide.

In the above preferable implementation, after the alkali solution treatment, dipping the plastic substrate with the ink layer in a metal catalyst solution in temperature of 20 °C to 60 °C for 1 mins to 30 mins so as to activate the surface of the plastic substrate which is exposed in the at least one hollow pattern.

In the above preferable implementation, the metal catalyst solution includes Pd, Ag, Cu, Ni, Au, Pt or Co.

In the above preferable implementation, after the metal catalyst solution treatment, soaking the plastic substrate with the ink layer in an electroless plating solution to form the copper plating layer.

In the above preferable implementation, the electroless plating solution has a pH above 11.

In the above preferable implementation, in step (d), using water or ethanol to remove the ink layer.

### BRIEF DESCRIPTION OF THE DRAWINGS

FIG. 1 is a flowchart of a trace forming method according to the present invention; and
FIG. 2 is a schematic diagram of a trace formed on a substrate according to the present invention.

### DETAILED DESCRIPTION OF THE PREFERRED EMBODIMENT

Advantages and features of the present invention and a method for achieving them are more easily understood in more detailed description with reference to exemplary embodiments and the accompanying drawings. However, the present invention may be implemented in different forms and it should not be understood as only limited to the embodiments described herein. On the contrary, for a person of ordinary skilled in the art, the provided embodiments make this disclosure express the scope of the present invention more thoroughly, fully, and completely.

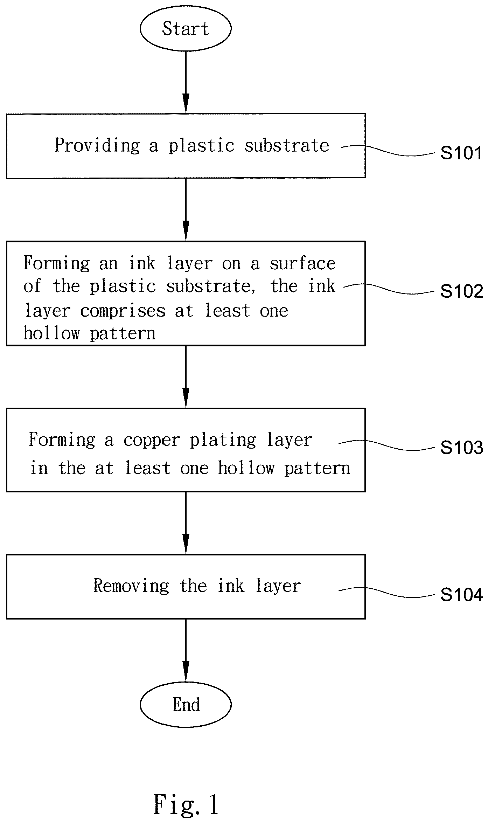

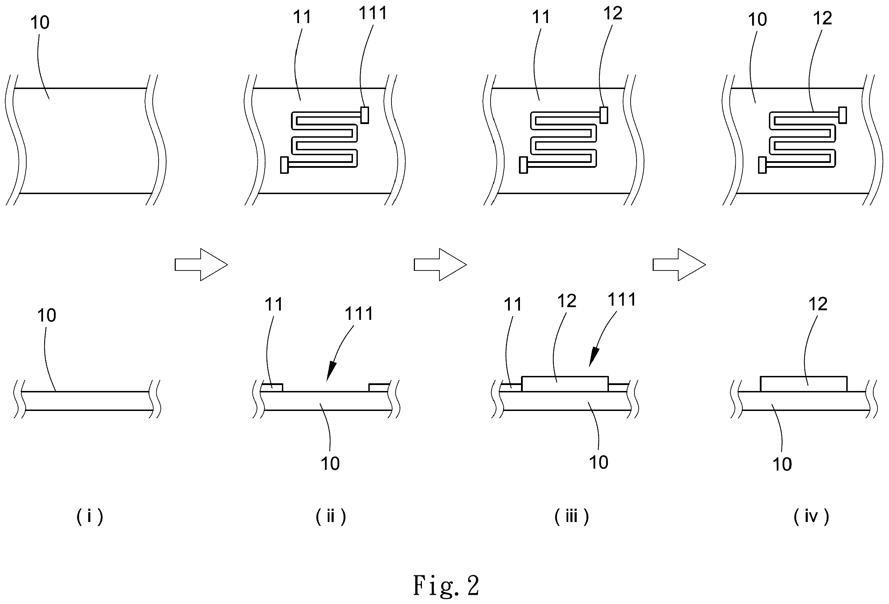

First, referring to FIG. 1 and FIG. 2, FIG. 1 is a flowchart of a trace forming method according to the present invention; FIG. 2 is a schematic diagram of a trace formed on a substrate according to the present invention. First, providing a plastic substrate 10 (step S101). In step S101, plastic substrate 10 (as shown in (i) of FIG. 2) is a flexible or rigid film. The material of the plastic substrate 10 could be polyimide (PI) or polyester (PET) therefore the surface of the plastic substrate 10 has imide groups expressed by the formula (1),

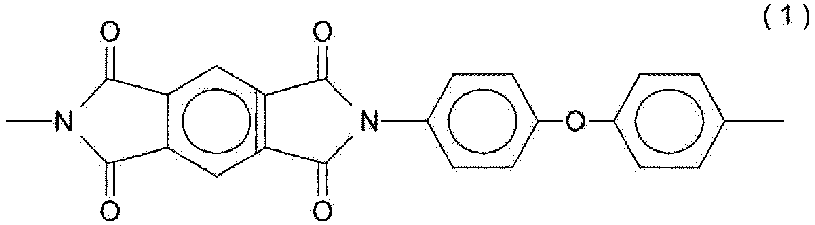

Then, forming an ink layer 11 on a surface of the plastic substrate 10, the ink layer 11 comprises at least one hollow pattern 111 (step 102). In step 102, a water washable mask ink is printed on a surface of the plastic substrate 10 by using screen printing. The plastic substrate 10 with water washable mask ink is put into an oven and heated at temperature of 30 °C to 200 °C for 5 mins to 30 mins to dry the water washable mask ink, then an ink layer 11 including at least one hollow pattern 111 is formed on the plastic substrate, and part surface of the plastic substrate is exposed in the at least one hollow pattern 111 (as shown in (ii) of FIG. 2). In this embodiment, the water washable mask ink comprises fillers, dispersants, solvents, binders and thickeners.

The total weight of the water washable mask ink as a basis, the concentration of said fillers is about 0.01 wt% to 30 wt% and includes ceramic materials, carbon materials, polymer-based fillers or glass fibers. The concentration of said dispersants contains about 0.05 wt% to 20 wt% and can be either ionic or non-ionic dispersants. The concentration of said solvents is about 30 wt% to 90 wt% and selected from the organic, inorganic and aqueous system. The concentration of said binders is about 5 wt% to 50 wt% and is a mixture of polymers or resins with functional groups such as ester and amide bonds. The concentration of said thickeners is about 0.01 wt% to 10 wt% and makes the water washable mask ink have characteristic of high viscosity. In some other embodiment, the water washable mask could be consisted without the fillers.

Next, forming a copper plating layer 12 in the at least one hollow pattern 111 (step 103) (as shown in (iii) of FIG. 2). In step 103, the plastic substrate 10 with the ink layer 11 is soaked in an alkali solution in temperature of 20 °C to 60 °C for 1 min to 20 mins. The alkali solution is used to modify the surface of the plastic substrate 10 which is exposed in the hollow pattern 111. In this embodiment, the alkali solution is 0.1M to 10M of sodium hydroxide solution, 0.1M to 10M of potassium hydroxide or 0.1M to 10M mixture of sodium hydroxide and potassium hydroxide. After the alkali solution treatment, the imide rings of the formula (1) is cleaved as expressed by formula(2),

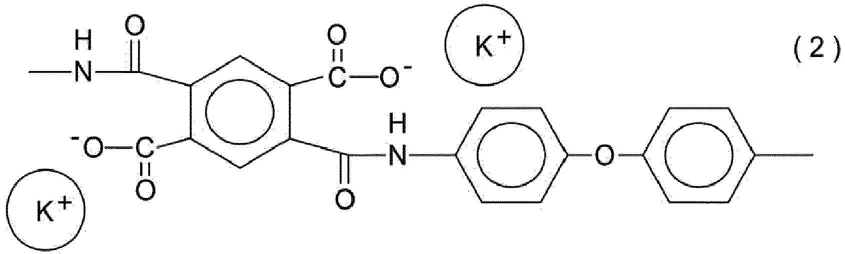

After the alkali solution treatment, the plastic substrate 10 with the ink layer 11 is dipped in a metal catalyst solution in temperature of 20 °C to 60 °C for 1 mins to 30 mins so as to activate the surface of the plastic substrate 10 which is exposed in the hollow pattern 111. Said metal catalyst solution includes Pd, Ag, Cu, Ni, Au, Pt or Co. During the activation reaction, the ions of the formula (2) are exchanged as expressed by formula (3),

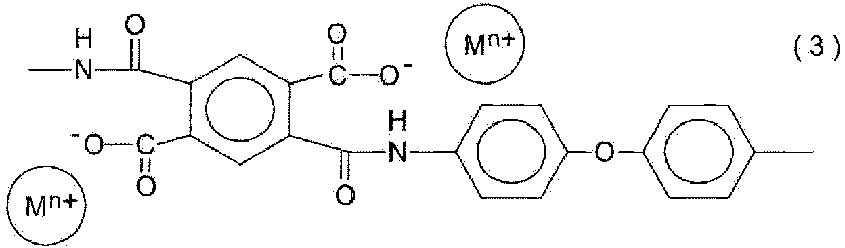

Where Mⁿ⁺ is Pd, Ag, Cu, Ni, Au, Pt or Co. Then, the plastic substrate 10 with the ink layer 111 is soaked in an electroless plating solution to form the copper plating layer 12 (step S103) (as shown in (iii) of FIG. 2.). The electroless plating solution is a formaldehyde-based electroless copper plating solution and has a pH above 11.

At last, removing the ink layer 11 (step S104) (as shown in (iv) of FIG. 2). In step 104, the ink layer 111 is removed by water washing or ethanol washing to form a circuit board. The copper plating layer 12 on the plastic substrate 10 is used as a trace of the circuit board such as FPCs.

### Example 1

A surface masked PI film is dipped in 1 M of KOH solution for 10 min to modify the surface of the plastic substrate which is exposed in a hollow pattern of an ink layer. Then the surface modified film PI film is soaked in a metal catalyst solution containing 50 g/L of Ni (NO₃)₂ and 50 mL/L of ammonium hydroxide for 10 min to active the surface of PI film. Then, the surface activated PI film is placed into a formaldehyde-based plating bath in the temperature of 20 °C to 60 °C for 5 mins to 60 mins to form a copper plating layer in hollow pattern. At last, the ink layer mask is removed by ethanol washing.

### Example 2

A surface masked PI film is dipped in 1 M of KOH solution for 10 min to modify the surface of the plastic substrate which is exposed in a hollow pattern of an ink layer. Then the surface modified film PI film is soaked in a metal catalyst solution containing 80 g/L of Co (NO₃)₂ and 40 mL/L of ammonium hydroxide for 10 min to active the surface of PI film. Then, the surface activated PI film is placed into a formaldehyde-based plating bath in temperature of 20 °C to 60 °C for 5 mins to 60 mins to form a copper plating layer in hollow pattern. At last, the ink layer mask is removed by ethanol washing.

Compared with the known technology, the present invention provides a trace forming method and it could reduce usage amount of the traditional etching chemicals within heavy metal, strong acids and strong oxidants, so it is friendly to the earth. In the other hand, there is no need to etch on the sputtering layer or the electroless plating layer so as to enhance the yield rate of the FPCs. Therefore, the present invention actually is a creation with a high industrial value.

All sorts of modifications can be made to the present invention by a person skilled in the art, without departing from the protection scope of the appended claims.

## Claims

1. A method for forming trace of circuit board, comprising the following steps:
(a) providing a plastic substrate (10);
(b) forming an ink layer (11) on a surface of the plastic substrate (10), the ink layer (11) comprises at least one hollow pattern (111 ;
(c) forming a copper plating layer (12) in the at least one hollow pattern (111); and
(d) removing the ink layer (11).

2. The method for forming trace of circuit board according to claim 1, wherein in step (a), the material of the plastic substrate (10) is polyimide or polyester.

3. The method for forming trace of circuit board according to claim 1, wherein in the step (a), the plastic substrate (10) is a flexible or rigid film.

4. The method for forming trace of circuit board according to claim 1, wherein in step (b), the material of the ink layer (11) is a water washable mask ink.

5. The method for forming trace of circuit board according to claim 4, wherein the water washable mask ink comprises dispersants, solvents, binders and thickeners.

6. The method for forming trace of circuit board according to claim 5, wherein the water washable mask ink further comprises fillers.

7. The method for forming trace of circuit board according to claim 6, wherein the total weight of water washable mask ink as a basis, the concentration of the fillers is about 0.01 wt% to 30 wt%.

8. The method for forming trace of circuit board according to claim 6, wherein the fillers include ceramic materials, carbon materials, polymer-based fillers or glass fibers.

9. The method for forming trace of circuit board according to claim 5, wherein the binder contains polymers or resins with functional groups such as ester and amide bonds.

10. The method for forming trace of circuit board according to claim 5, wherein the total weight of water washable mask ink as a basis, the concentration of the binders is about 5 wt% to 50 wt%.

11. The method for forming trace of circuit board according to claim 4, wherein in step (b), using screen printing to print the water washable mask ink on the plastic substrate (10) and drying the water washable mask ink in temperature of 30 to 200 °C for 5 mins to 30 mins.

12. The method for forming trace of circuit board according to claim 1, wherein in step (c), soaking the plastic substrate (10) with the ink layer (11) in an alkali solution in temperature of 20 °C to 60 °C for 1 min to 20 mins so as to modify the surface of the plastic substrate (10) which is exposed in the at least one hollow pattern (111).

13. The method for forming trace of circuit board according to claim 12, wherein the alkali solution is 0.1 M to 10 M of sodium hydroxide solution, 0.1 to 10 M of potassium hydroxide or 0.1 M to 10 M of mixture of sodium hydroxide and potassium hydroxide.

14. The method for forming trace of circuit board according to claim 12, wherein after the alkali solution treatment, dipping the plastic substrate (10) with the ink layer (11) in a metal catalyst solution in temperature of 20 °C to 60 °C for 1 mins to 30 mins so as to activate the surface of the plastic substrate (10) which is exposed in the at least one hollow pattern (111).

15. The method for forming trace of circuit board according to claim 14, wherein the metal catalyst solution includes Pd, Ag, Cu, Ni, Au, Pt or Co .

16. The method for forming trace of circuit board according to claim 14, wherein after the metal catalyst solution treatment, soaking the plastic substrate (10) with the ink layer (11) in an electroless plating solution to form the copper plating layer (12).

17. The method for forming trace of circuit board according to claim 16, wherein the electroless plating solution has a pH above 11.

18. The method for forming trace of circuit board according to claim 1, wherein in step (d), using water or ethanol to remove the ink layer (11).
